# EUROPÄISCHE PATENTSCHRIFT

(11) **EP 1 546 029 B1**
(45) Veröffentlichungstag und Bekanntmachung des Hinweises auf die Patenterteilung: **13.01.2016**
(21) Anmeldenummer: 03709637.7
(22) Anmeldetag: 21.02.2003
(51) Int. Cl.: B81C 1/00

(54) **VERFAHREN ZUR HERSTELLUNG EINER MIKROMECHANISCHEN VORRICHTUNG, INSBESONDERE EINER MIKROMECHANISCHEN SCHWINGSPIEGELVORRICHTUNG**
METHOD FOR THE PRODUCTION OF A MICROMECHANICAL DEVICE, PARTICULARLY A MICROMECHANICAL OSCILLATING MIRROR DEVICE
PROCEDE POUR FABRIQUER UN DISPOSITIF MICROMECANIQUE, NOTAMMENT UN MIROIR OSCILLANT MICROMECANIQUE

(30) Priorität: 02.08.2002 DE 10235371
(43) Veröffentlichungstag der Anmeldung: 29.06.2005
(73) Patentinhaber: ROBERT BOSCH GMBH, 70442 Stuttgart (DE)
(72) Erfinder: METZGER, Lars, 72458 Albstadt (DE); FISCHER, Frank, 72810 Gomaringen (DE)
(86) Internationale Anmeldenummer: PCT/DE2003/000550
(87) Internationale Veröffentlichungsnummer: WO 2004/016547

(56) Entgegenhaltungen:
- WO-A-02/12116
- WO-A-96/08036
- WO-A-97/15066
- DE-A- 4 000 496
- DE-A- 19 847 455
- US-B1- 6 388 300
- GENNISSEN ET AL: "Bipolar-compatible epitaxial poly for smart sensors: stress minimization and applications", SENSORS AND ACTUATORS A, ELSEVIER SEQUOIA S.A., LAUSANNE, CH, vol. 62, no. 1-3, 1 July 1997 (1997-07-01) , pages 636-645, XP022542084, ISSN: 0924-4247, DOI: 10.1016/S0924-4247(97)01498-2

## Beschreibung

Die Erfindung betrifft ein Verfahren zur Herstellung einer mikromechanischen Vorrichtung, insbesondere einer mikromechanischen Schwingspiegelvorrichtung, durch Freilegen eines vertikal auslenkbaren, insbesondere verkippbaren, Inselbexeiches aus Silizium mittels eines Ätzprozesses in einer unter dem Inselbereich liegenden Siliziumsubstratschicht.

Ein derartiges Verfahren ist bereits sowohl aus der Offenlegungsschrift DE 197 57 197 A1 wie aus der Patentschrift US 5,198,390 bekannt, auf die weiter unten noch näher eingegangen wird.

Obwohl auf beliebige mikromechanische Vorrichtungen und Strukturen, insbesondere optische Schalter und Lichtmodulatoren für Displays, anwendbar, werden die vorliegende Erfindung sowie die ihr zu Grunde liegende Problematik in Bezug auf eine in der Technologie der Silizium-Oberflächenmikromechanik herstellbare mikromechanische Schwingspiegelvorrichtung erläutert.

Mikromechanische Schwingspiegelvorrichtungen werden beispielsweise in der integrierten Optik eingesetzt, um den Weg von Lichtstrahlen zwischen einzelnen oder in einem Array angeordneten Lichtwellenleitern (optischen Fasern) umzuschalten. Derartige Schwingspiegelvorrichtungen sind in verschiedenen Designvarianten bekannt und verfügen über einen steuerbaren - im Spiegel integrierten oder neben dem Spiegel auf dem gleichen Chip angeordneten - Antrieb, der die Verkippbewegungen der Spiegeloberfläche und damit die optischen Schaltvorgänge generiert.

Diese Verkippbewegungen, bei denen der bewegliche, mikromechanisch freigelegte Teil der Schwingspiegelvorrichtung, also der Inselbereich - dessen Oberseite die Spiegeloberfläche bildet -, Torsionsschwingungen ausführen kann, die eine solche Amplitude aufweisen, dass ein Teil des Inselbereiches in den freigeätzten Bereich der Siliziumsubstratschicht hineinragt, setzen, je nach der Größe des gewünschten Kippwinkels, einen tiefgehenden Freiraum unter dem Inselbereich voraus. Der freigeätzte Bereich muss natürlich auch lateral mindestens die Abmessungen des Inselbereiches aufweisen.

Große Auslenkungen senkrecht zur Chipfläche, wie sie für Schwingspiegelvorrichtungen oder andere optische Bauelemente in der Mikromechanik (optical MEMS) erforderlich sind, können bisher nicht in Oberflächenmikromechanik hergestellt werden, da die üblichen eingesetzten Opferschichten bzw. Ätztechniken nur die Bewegung der freigelegten Strukturen um wenige Mikrometer senkrecht zu Oberfläche, entsprechend einem für viele Anwendungen zu geringen Kippwinkel von nur wenigen Grad, erlauben.

Optische Bauelemente mit großen vertikalen Auslenkungen, insbesondere Schwingspiegelvorrichtungen, werden deshalb derzeit, wie beispielsweise aus der oben zitierten DE 197 57 197 A1 bekannt, meist dadurch erzielt, dass die Spiegelstrukturen von der Wafer-Vorderseite strukturiert und mit Methoden der Volumen- (Bulk) Mikromechanik von der Rückseite der Trägersubstrate gelöst werden. Dabei wird in der Regel SOI-Material verwendet und es ist erforderlich, die Siliziumsubstratschicht von der Rückseite her mittels einer anisotropen Nassätzung bis zur oberen Siliziumschicht (bzw. Oxidschicht) durchzuätzen, während das laterale Freilegen des Inselbereiches - vor oder nach der Nassätzung - durch ein Trockenätzverfahren erfolgt.

Ein Vorderseiten-Tiefenätzverfahren, mit dem mikromechanische Strukturen lateral und vertikal freilegbar sind, ist aus der eingangs genannten US 5,198,390 bekannt. Der dortige, so genannte SCREAM-Prozess (single crystal reactive etch and metallization process) geht von einem einheitlichen, also nicht in separate Funktions- und Opferschichten unterteilbaren, einkristallinen Silizium-Wafer aus, bei dem alle Strukturierungs- und Tiefenätz-Schritte durchgehend mittels reaktivem Ionen-Ätzen (RIE) vorgenommen werden. Dabei wird zunächst die Ätzmaske durch RIE-Ätzen strukturiert, anschließend werden die entsprechenden Grabenstrukturen im Wafer durch RIE-Tiefenätzen erzeugt, dann wird durch selektives Maskieren der Seitenwände der Gräben die freizulegende Struktur definiert, und schließlich wird der Substratbereich unterhalb der selektierten (Insel)Struktur durch vollständiges Unterätzen mittels RIE freigelegt. Der SCREAM-Prozess zeichnet sich einerseits durch eine hohe Prozesseinheitlichkeit aus, andererseits erfolgt das Unterätzen mit einer prozesstypisch geringen Ätzrate, die sich insbesondere bei breiten selektierten (Inse1)Strukturen negativ auswirkt. Besonders problematisch im Hinblick auf Anwendungen insbesondere bei Schwingspiegelvorrichtungen erscheint die Tatsache, dass die - ungeschützte - Unterseite der selektierten (Insel)Struktur beim Unterätzen des darunter liegenden Bereiches des Siliziumssubstrats zum Teil erheblich mit angegriffen wird.

Der Erfindung liegt die Aufgabe zugrunde, ein verbessertes Herstellungsverfahren der eingangs genannten Art anzugeben, das sich insbesondere auf oberflächenmikromechanische Prozessschritte beschränkt.

Die WO 02/12116 A2 offenbart anisotropes Grabenätzen in einer Siliziumschicht bis zu einer vergrabenen Oxidschicht, Erzeugen einer Passivierungsschicht auf den Grabenwänden, Öffnen des Grabenbodens und Durchführen eines isotropen Opferschichtätzschrittes.

Ein Verfahren der eingangs genannten Art löst diese Aufgabe durch die Schritte:,
- Bereitstellen eines SOI- oder EOI-Substrats mit einer Si-Funktionsschicht, welche unter Zwischensetzen einer Oxidschicht auf einer Siliziumsubstratschicht vorgesehen ist, deren oberer Bereich als Opferschicht vorgesehen ist ;
- Bilden mindestens eines durch die Funktionsschicht bis zur Oxidschicht reichenden Grabens durch einen ersten anisotropen Plasmaätzschritt, der den späteren Inselbereich lateral gegenüber der Funktionsschicht freilegt ;
- Erzeugung einer mindestens die Seitenwände des Grabens bedeckenden Passivierungsschicht und anschließendes Öffnen des Grabenbodens bis zur Siliziumsubstratschicht durch ein physikalisches gerichtetes Ätzverfahren ;
- Tiefenätzen des Grabens mit einem zweiten anisotropen Plasmaätzschritt vom geöffneten Grabenboden aus bis in eine vorbestimmte Tiefe der Siliziumsubstratschicht, wobei dieser Plasmaätzschritt die Tiefe der Opferschicht definiert ; und
- Durchführen eines isotropen Opferschichtätzschrittes zum Entfernen eines Bereiches der Opferschicht unter dem Inselbereich durch laterales, vom Graben ausgehendes Unterätzen der Siliziumsubstratschicht, derart, dass der Inselbereich freigelegt und vertikal beweglich gemacht wird.

Die der vorliegenden Erfindung zugrunde liegende Idee besteht zunächst darin, von der Vorderseite eines SOI- bzw. EOI(Epipoly on insulator)-Substrats aus in zwei aufeinander folgenden, getrennten Tiefenätzschritten bis in die gewünschte Tiefe der Siliziumsubstratschicht vorzudringen und diese teilweise - genauer: in ihrem oberen, oxidschichtnahen Bereich - als Opferschicht zum vertikalen Freilegen der oberhalb der Oxidschicht in der Funktionsschicht positionierten Inselstrukturen zu verwenden. Das erfindungsgemäße Konzept eines Opferschichtprozesses zu Erzeugung großer vertikaler Auslenkungen basiert auf rein oberflächenmikromechanischen Prozessschritten.

Gemäß der Erfindung wird in einem ersten Schritt eine (Spiegel)struktur mit einem Tiefenätzverfahren in SOI bzw. EOI erzeugt. Hierfür kann jedes für die Funktionsschicht geeignete anisotrope Plasmaätzverfahren eingesetzt werden, bevorzugt jedoch das aus der Patentschrift DE 42 41 045 C1 bekannte fluorbasierte Si-Tiefenätzenverfahren, welches alternierend aufeinander folgende getrennte Ätz- und Polymerisatiosschritte umfasst. Nähere Einzelheiten können dieser Patentschrift entnommen werden. Der Ätzstopp findet auf der Oxidschicht statt.

Nach dem ersten Tiefenätzschritt wird die (Spiegel)Struktur mit einer weiteren Schicht passiviert. Die Passivierung wird in den Strukturgräben der (Spiegel) struktur geöffnet. Es folgt ein zweiter Tiefenätzschritt, mit dem die Opferschicht - hier: der oxidschichtnahe, obere Bereich der Siliziumsubstratschicht - in die Tiefe erschlossen wird. Die Tiefe der Opferschicht wird also erfindungsgemäß im Wesentlichen (d. h. bis auf die bei den involvierten Ätzungen prozesstypisch auftretenden Ungenauigkeiten) durch einen definierten zweiten Tiefenätzprozess eingestellt. Um die (Spiegel)Struktur vollständig zu lösen, schließt sich ein isotroper lateraler Trockenätzschritt an.

Die Erfindung ermöglicht die Verwendung bekannter Prozesse der Halbleitertechnologie und eine durchgängige Vorderseiten-Prozessierung um mikromechanische Vorrichtungen zu realisieren, die große Auslenkungen mit einer Bodenfreiheit von ca. 1 bis 200 µm zulassen. Des Weiteren ist eine hohe Prozesskontrolle, insbesondere eine exakte Tiefeneinstellung auf ±5%, möglich. Ein besonderer Vorteil des Verfahrens sind die hohen vertikalen und lateralen Ätzraten.

Eine durch die Verwendung von EOI-Substrat gegebene gute Kontrolle des Stressgradienten (Spiegeloberseite/-unterseite) in der Funktionsschicht ermöglicht eine hohe Auflösung bzw. eine einstellbare Wölbung der Spiegeloberfläche in optischen Systemen. Ferner sind erfindungsgemäß relativ dünne Spiegel (Größenordnung: < 10 µm, im Vergleich zu 50 µm Dicke der Funktionsschicht bei von der Wafer-Rückseite her durchgeätzten Substraten) möglich (Epipoly, LPCVD-Si, Oxidschichten oder Metallschichten als ursprüngliches, bzw. nachträglich als weitere Schicht(en) abgeschiedenes, Spiegelmaterial). Auf Grund dieser geringen Dicke des Spiegels und der dementsprechend geringen Masse können hohe Eigenfrequenzen und damit eine hohe Schaltgeschwindigkeit optischer Bauelemente erreicht werden.

Darüber hinaus besteht die Möglichkeit der Kombination des erfindungsgemäßen Opferschichtprozesses mit weiteren Herstellungsschritten, beispielsweise zur Erzeugung von weiteren Funktionsebenen ober- oder unterhalb der Spiegelstrukturebene und zusätzlicher Opferschichttechnik (z. B. Gasphasenätzen von Oxiden), etwa für die Herstellung von Antriebsstrukturen (z. B. Elektroden) in zweiter Epipoly-Strukturebene bzw. von dünnen Torsionsfedern. Das Verfahren gemäß der Erfindung kann Teil eines komplexen Gesamtprozesses sein, in welchem im Substrat zum Beispiel vergrabene Leiterbahnen und/oder weitere Halbleiterstrukturen erzeugt werden.

In den Unteransprüchen finden sich vorteilhafte Weiterbildungen und Verbesserungen des in Anspruch 1 angegebenen Herstellungsverfahrens.

Gemäß einer besonders bevorzugten Weiterbildung erfolgt der Opferschichtätzschritt selektiv zur Passivierungsschicht und zur Oxidschicht. Dies hat entscheidende Vorteile für die Präzisionseigenschaft des Prozesses. Zum einen können dünne Spiegelstrukturen erzeugt werden, da diese im folgenden Opferschichtätzschritt nicht angegriffen, d. h. nicht verbraucht werden. Diese inerten Eigenschaften sind insbesondere auch beim Herstellen relativ großer (2-3 mm) Inselbereiche wichtig, da der isotrope Gasphasenätzschritt, ausgehend von einem einzigen peripheren Graben, eine nicht vernachlässigbare Zeit braucht, um sich bis zur Mitte des zu erzeugenden Freiraums vorzuarbeiten.

Um diese Zeit zu verkürzen, bzw. um die passivierten Funktionsstrukturen keinem allzu lang andauernden Ätzangriff auszusetzen, ist es vorteilhaft, dass innerhalb des Inselbereiches weitere Grabenstrukturen vorgesehen und bis in Opferschichttiefe geätzt werden, so dass der Opferschichtätzschritt gleichzeitig von allen Gräben ausgehend - schneller - durchführbar ist. Auf Grund der Passivierungsschicht und der hohen isotropen Ätzraten sind, im Vergleich zum SCREAM-Verfahren, jedenfalls vorteilhafterweise erheblich weniger derartige Perforationslöcher erforderlich.

Eine besonders vorteilhafte Ausgestaltung des Verfahrens besteht in der Herstellung einer mikromechanischen Schwingspiegelvorrichtung. Dabei ist der Inselbereich über einen oder mehrere Verbindungsstege mit dem den Inselbereich umgebenden Bereich der Funktionsschicht verbunden, so dass der freigelegte Inselbereich um den einen oder die mehreren Verbindungsstege Bewegungen, vorzugsweise Torsionsschwingungen, ausführen kann, die eine solche Amplitude aufweisen, dass ein Teil des Inselbereiches in den freigeätzten Bereich der Siliziumsubstratschicht hineinragt.

Diese Ausgestaltung kann noch weiter verbessert werden, indem oberhalb des Grabens und der weiteren, als Perforationslöcher ausgebildeten, Grabenstrukturen mindestens eine weitere, insbesondere die Reflektivität der Spiegeloberfläche verbessernde, Schicht derart abgeschieden wird, dass die Perforationslöcher verschlossen werden, nicht aber der den Inselbereich vom umgebenden Bereich trennende Graben.

Dies kann in besonders vorteilhafter Weise dadurch erreicht werden, dass der den Inselbereich lateral freilegende Graben breiter als die weiteren Grabenstrukturen ausgebildet wird.

Prozesstechnisch ist es gemäß einer weiteren Weiterbildung des Verfahrens vorteilhaft, dass der Opferschichtätzschritt durch chemisches Trockenätzen mit einem der Gase XeF₂, ClF₃, NF₃ oder BrF₃ erfolgt.

Die Passivierungsschicht kann, gemäß einer weiteren Weiterbildung, durch CVD-Abscheidung oder durch thermische Oxidation aufgebracht werden.

Gemäß einer weiteren Weiterbildung des Verfahrens ist es vorteilhaft, die Passivierungsschicht und/oder die Oxidschicht nach dem Opferschichtätzschritt, insbesondere durch eine chemische Trockenätzung mit dem Gas HF/H₂O, wieder zu entfernen.

Ein Ausführungsbeispiel der Erfindung ist in den Figuren der Zeichnung dargestellt und in der nachfolgenden Beschreibung näher erläutert. Es zeigt
Figur 1 A und Figur 2 bis 8 eine schematische Querschnittsdarstellung (Querschnitt entlang AA' in Figur 1 B) des Herstellungsprozesses für eine Schwingspiegelvorrichtung gemäß der vorliegenden Erfindung,
Figur 1 B eine Draufsicht auf den Schwingspiegel (ohne Antrieb) im Prozessstadium von Figur 1 A.

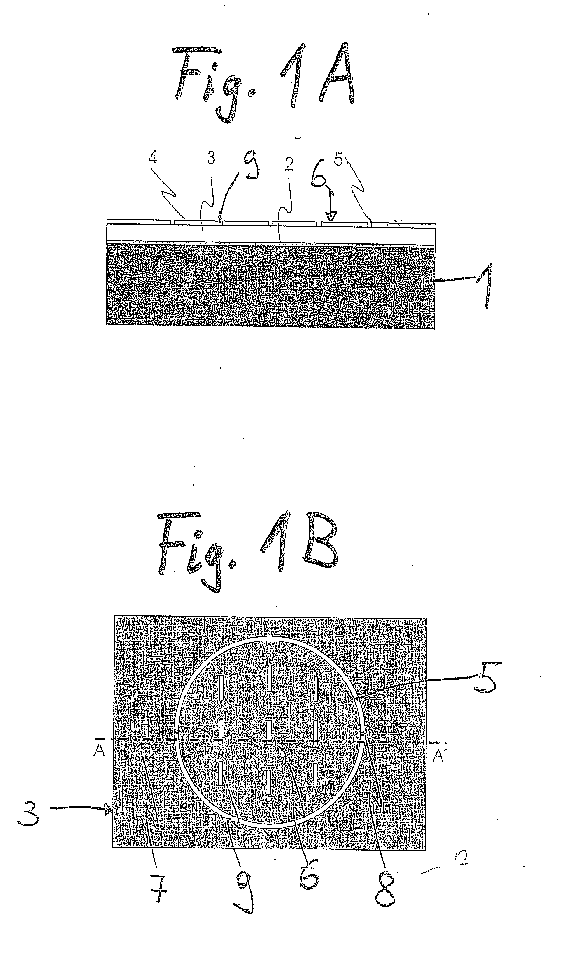

Figur 1 A zeigt beispielshalber eine EOI-Schichtenfolge mit einer Siliziumsubstratschicht 1 (n oder p dotiert, (100) oder (111) orientiert), einer Oxidschicht 2 aus thermischen oder CVD-Oxid, die ca. 50 nm bis 1 µm dick ist, einer Si-Funktionsschicht 3 aus Epipoly (oder, bei SOI, aus Polysilizium), und einer Ätzmaske 4, beispielsweise aus Lack oder Oxid.
Figur 1 B zeigt den (in diesem Prozessstadium jeweils nur in der Maskenstruktur 4 vorhandenen) Graben 5, der den Inselbereich 6 von dem umgebenden - unbeweglichen - Bereich 7 der Funktionsschicht 3 abgrenzt. Erkennbar sind ferner Torsionsfedern 8, an denen der Inselbereich 6, also die Spiegelstruktur, aufgehängt ist. Dadurch ist die Drehachse für den späteren Schwingspiegel definiert. Als Torsionsfedern 8 können Verbindungsstege, also schmale stehengelassene Bereiche der Funktionsschicht 3 verwendet werden.

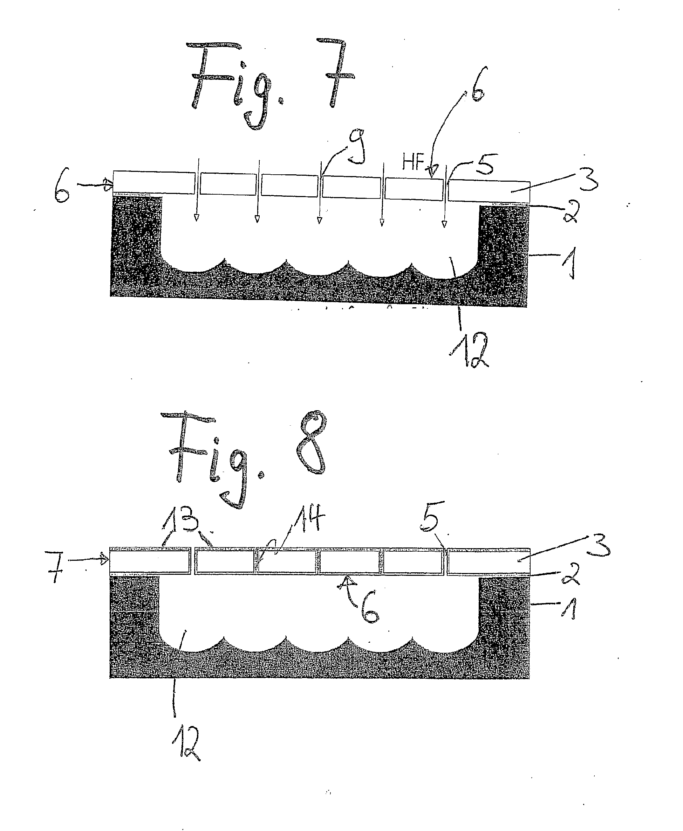

Die Oberseite der Spiegelstruktur 6 kann, wie ebenfalls aus den Figuren 1 A und 1 B hervorgeht, je nach lateraler Ausdehnung, mit mehr oder weniger vielen Perforationslöchern 9 versehen werden, auf die weiter unten bei der Beschreibung von Figur 8 noch näher eingegangen wird. Wenn derartige Perforationslöcher 9, also weitere (zukünftige) Grabenstrukturen, vorgesehen werden, so werden sie im Folgenden in die gleichen Tiefenätz- bzw. Passivierungsschritte einbezogen, wie der zu erzeugende Graben 5.

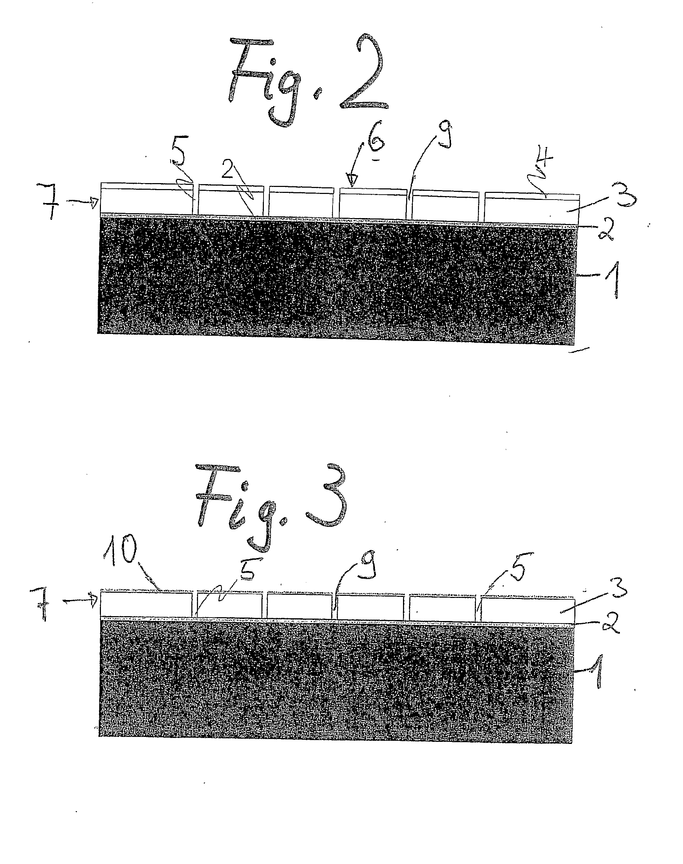

Das Ergebnis des nächsten Prozessschrittes, also nach Erfolgen des ersten anisotropen Plasmaätzschrittes, ist in Figur 2 gezeigt und lässt die in der Funktionsschicht 3 erzeugten Grabenstrukturen 5 und 9 erkennen. Dieser Ätzprozess verläuft selektiv zu Oxid und stoppt abrupt an der Oxidschicht 2. Der äußere Graben 5, der den beweglichen Inselbereich 6 von den feststehenden umgebenden Bereichen 7 separiert, sollte geringfügig breiter sein als die Perforationslöcher 9, wie unten, bei Figur 8, näher erläutert wird.

Figur 3 zeigt das Prozessstadium nach Abscheidung einer Passivierungsschicht 10 (auch und gerade in den Grabenstrukturen 5 und 9, dort jedoch nicht dargestellt). Diese Passivierungsschicht 10 wird bei einem nachfolgenden Opferschichtätzschritt, beispielsweise mit mindestens einen der Gase XeF₂, ClF₃, TNF₃ oder BrF₃, nicht oder nur in sehr geringem Maß angegriffen. Die Abscheidung erfolgt bevorzugt mit an sich bekannten Verfahren, wie thermische Oxidation, LPCVD (low pressure), PECVD (Plasma enhanced chemical vapour deposition) oder auch Ozon-unterstützte TEOS-Abscheidung. Außer der typischen Siliziumoxid-Passivierungsschicht können auch andere anorganische Passivierungsschichten verwendet werden (zum Beispiel Metalle, Nitride SiC, etc.), die eine ausreichende, stetige und im Idealfall homogene Kantenbedeckung im Bereich der Seitenwand aufweisen und in einem späteren Schritt selektiv gegenüber dem Inselbereich 6 geätzt werden können.

Bei der Wahl der in Frage kommenden Abscheideverfahren ist in jedem Fall darauf zu achten, dass in den Böden der Ätzgräben 5 und 9 nur eine geringe, später mit relativ geringem Aufwand wieder entfernbare, Deposition stattfindet.

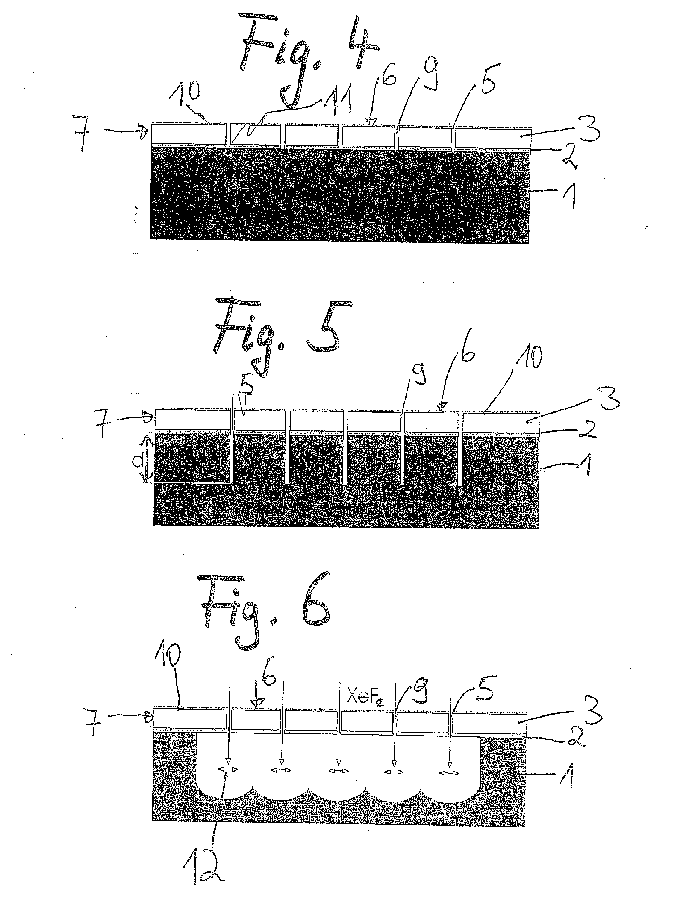

Figur 4 zeigt das nächste Prozessstadium, nachdem im Bereich der Grabenböden die Oxidschicht 2 (und die Passivierungsschicht 10) durch ein physikalisches gerichtetes Ätzverfahren geöffnet wurden, derart, dass Öffnungen 11 zur Siliziumsubstratschicht 1 hin entstehen. Bei dieser Ätzung ist darauf zu achten, die Seitenwandpassivierung nicht zu zerstören. Diese Forderung kann durch ein RIE oder ein anderes Verfahren mit einer geeigneten, senkrecht zur Wafer-Oberfläche wirkenden Plasmaführung, erfüllt werden.

Figur 5 zeigt das Verfahrensstadium, nachdem der Graben 5 und die weiteren Grabenstrukturen 9 mit einem zweiten anisotropen Plasmaätzschritt in die gewünschte Tiefe d geätzt wurden, wobei durch diese Tiefe d im Wesentlichen die Tiefe des anschließenden (vgl. Figur 6) Opferschichtätzprozesses vorgegeben wird.

Figur 6 zeigt das Prozessstadium, in welchem durch einen isotropen Silizium-Ätzschritt die Grabenstruktur 5 und 9 lateral geätzt wird. Durch die eingebrachte Passivierungsschicht 10 und die Oxidschicht 2 bleibt die Spiegelstruktur 6 trotz des massiven Unterätzens der Siliziumsubstratschicht 1 unversehrt. Der Ätzprozess kann beispielsweise mit den Gasen XeF₂, ClF₃, NF₃ oder BrF₃ im Wege des Gasphasenätzens mit relativ hoher Ätzrate durchgeführt werden. Die Pfeile in Figur 6 deuten das Eindringen von XeF₂ bis in die Tiefe d der Siliziumsubstratschicht 1 an. Bei großen lateralen Breiten (2 bis 3 mm) der Inselstruktur 6 ist es vorteilhaft, wenn diese durch einen sich von mehreren Grabenstrukturen 5 und 9 gleichzeitig ausbreitenden Ätzprozess freigelegt wird.

Durch den isotropen Ätzprozess wird ein definierter Bereich 12 unterhalb des Inselbereiches 6 entfernt. Prinzipiell kann der Inselbereich 6 nunmehr in die dabei in der Siliziumsubstratschicht 1 zurückgelassene Ausnehmung hinein ausgelenkt werden. Dies bringt keine Probleme hinsichtlich der mechanischen Stabilität mit sich, da, selbst bei einer Ätztiefe d von 200 µm, die Siliziumsubstratschicht 1, die ca. 600-700 µm dick ist, mit ausreichender Substanz erhalten bleibt.

Bei Bedarf ist es, wie in Figur 7 dargestellt, ohne weiteres möglich, die Passivierungsschicht 10 (und die Oxidschicht 2) nach dem isotropen Silizium-Opferschichtätzschritt mit einem bekannten Verfahren, beispielsweise einer chemische Trockenätzung mit dem Gas HF/H₂O, wieder zu entfernen. Dies ist durch die Pfeile in Figur 7 angedeutet.

Ebenso ist es, wie in Figur 8 dargestellt, bei Bedarf möglich, eine oder mehrere zusätzliche Schichten 13 auf der - gegebenenfalls noch durch die weiteren Grabenstrukturen 9 perforierten - Spiegelfläche, also auf der Oberseite des Inselbereiches 6, abzuscheiden. Dadurch kann beispielsweise die Reflektivität der Spiegeloberfläche verbessert werden. Als Abscheideprozess wird bevorzugt ein Verfahren gewählt, bei dem eine konforme Kantenbedeckung eintritt (zum Beispiel LPCVD von Si oder Ge oder SiGe, oder eine Metallisierung) und bei dem es zum Verschluss 14 der ggf. vorhandenen schmalen Perforationslöcher (Breite < 4 µm) kommt. Beim Design der Spiegelschicht 13 muss darauf geachtet werden, dass der Graben 5, der bewegliche 6 von festen Strukturen 7 trennt, breiter ist als die Perforationslöcher 9. Dadurch kann im Bereich des Grabens 5 ein unerwünschter, die Funktion des Schwingspiegels 6 beeinträchtigender Verschluss vermieden werden. Für etwaige weitere Oberseiten-Prozessschritte kann demnach nach bzw. durch die Beschichtung 13 eine geschlossene Spiegeloberfläche angeboten werden.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Beispielsweise können an sich bekannte, in den Figuren nicht dargestellte, weitere Prozessschritte vorgesehen werden, um ein als elektrostatischen Antrieb wirkendes Aktorelement zur Bewegung des Schwingspiegels 6 zu realisieren. Dieses Aktorelement kann beispielsweise einen von außen mit einer Spannung beaufschlagbaren Kondensator umfassen, dessen eine Elektrode am Grund der durch den entfernten Bereich 12 zurückgelassenen Ausnehmung, und dessen andere Elektrode von der Unterseite der Inselstruktur 6 gebildet wird. Es ist jedoch auch eine räumliche Trennung von Spiegelelement 6 und Aktorelement (auf einem Chip) möglich.

Mit dem erfindungsgemäßen Herstellungsverfahren lassen sich mikromechanische Schwingspiegel für sehr große Amplituden zum Einsatz in Baulasern, Barcode-Lasern, Raumüberwachung, Sitzbelegungserkennung in Kfz o. ä., herstellen.

Schließlich wurde in dem obigen Ausführungsbeispiel eine Spiegelstruktur gezeigt, doch ist die Erfindung auch auf Strukturen anwendbar, bei denen der Inselbereich 6 nicht ein Spiegelelement, sondern ein sonstiger mechanischer Aktor, wie zum Beispiel ein Stellglied oder Ähnliches ist.

## Patentansprüche

1. Verfahren zur Herstellung einer mikromechanischen Vorrichtung, insbesondere einer mikromechanischen Schwingspiegelvorrichtung, durch Freilegen eines vertikal auslenkbaren, insbesondere verkippbaren, Inselbereiches (6) aus Silizium mittels eines Ätzprozesses in einer unter dem Inselbereich liegenden Siliziumsubstratschicht (1), mit den Schritten:
- Bereitstellen eines SOI- oder eines Epipoly on Insulator-Substrats mit einer Si-Funktionsschicht (3), welche unter Zwischensetzen einer Oxidschicht (2) auf einer Siliziumsubstratschicht (1) vorgesehen ist, deren oberer Bereich als Opferschicht vorgesehen ist;
- Bilden mindestens eines durch die Funktionsschicht (3) bis zur Oxidschicht (2) reichenden Grabens (5) durch einen ersten anisotropen Plasmaätzschritt, der den späteren Inselbereich (6) lateral gegenüber der Funktionsschicht (3) freilegt;
- Erzeugung einer mindestens die Seitenwände des Grabens (5) bedeckenden Passivierungsschicht (10) und anschließendes Öffnen des Grabenbodens bis zur Siliziumsubstratschicht (1) durch ein physikalisches gerichtetes Ätzverfahren;
- Tiefenätzen des Grabens (5) mit einem zweiten anisotropen Plasmaätzschritt vom geöffneten Grabenboden (11) aus bis in eine vorbestimmte Tiefe der Siliziumsubstratschicht (1), wobei dieser Plasmaätzschritt die Tiefe der Opferschicht definiert; und
- Durchführen eines isotropen Opferschichtätzschrittes zum Entfernen eines Bereiches (12) der Opferschicht unter dem Inselbereich (6) durch laterales, vom Graben (5) ausgehendes Unterätzen der Siliziumsubstratschicht (1), derart, dass der Inselbereich (6) freigelegt und vertikal beweglich gemacht wird.

2. Verfahren nach Anspruch 1, **dadurch gekennzeichnet, daß** es ein Verfahren zur Herstellung einer mikromechanischen Schwingspiegelvorrichtung ist.

3. Verfahren nach Anspruch 1 oder 2, **dadurch gekennzeichnet, dass** der Opferschichtätzschritt selektiv zur Passivierungsschicht (10) und zur Oxidschicht (2) erfolgt.

4. Verfahren zur Herstellung einer mikromechanischen Schwingspiegelvorrichtung nach Anspruch 3, **dadurch gekennzeichnet,**
- **dass** der Inselbereich (6) über einen oder mehrere Verbindungsstege (8) mit dem den Inselbereich (6) umgebenden Bereich (7) der Funktionsschicht (3) verbunden ist,
- so dass der freigelegte Inselbereich (6) um den einen oder die mehreren Verbindungsstege (8) Bewegungen, vorzugsweise Torsionsschwingungen, ausführen kann, die eine solche Amplitude aufweisen, dass ein Teil des Inselbereiches (6) in den freigeätzten Bereich (12) der Siliziumsubstratschicht (1) hineinragt.

5. Verfahren nach Anspruch 4, **dadurch gekennzeichnet, dass** als Verbindungsstege (8) schmale stehengelassene Bereiche der Funktionsschicht (3) verwendet werden.

6. Verfahren nach einem der Ansprüche 1 bis 5, **dadurch gekennzeichnet, dass** innerhalb des Inselbereiches (6) weitere Grabenstrukturen (9) vorgesehen und bis in Opferschichttiefe geätzt werden, so dass der Opferschichtätzschritt gleichzeitig von allen Gräben (5, 9) ausgehend durchführbar ist.

7. Verfahren nach Anspruch 6, **dadurch gekennzeichnet, dass** oberhalb des Grabens (5) und der weiteren, als Perforationslöcher ausgebildeten, Grabenstrukturen (9) mindestens eine weitere, insbesondere die Reflektivität der Spiegeloberfläche verbessernde, Schicht (13) derart abgeschieden wird, dass die Perforationslöcher (9) verschlossen werden, nicht aber der den Inselbereich (6) vom umgebenden Bereich (7) trennende Graben (5).

8. Verfahren nach Anspruch 6 oder 7, **dadurch gekennzeichnet, dass** der den Inselbereich (6) lateral freilegende Graben (5) breiter als die weiteren Grabenstrukturen (9) ausgebildet wird.

9. Verfahren nach einem der Ansprüche 1 bis 8, **dadurch gekennzeichnet, dass** der Opferschichtätzschritt durch chemisches Trockenätzen mit einem der Gase XeF₂, ClF₃, NF₃ oder BrF₃ erfolgt.

10. Verfahren nach einem der Ansprüche 1 bis 9, **dadurch gekennzeichnet, dass** die Passivierungsschicht (10) durch CVD-Abscheidung oder durch thermische Oxidation aufgebracht wird.

11. Verfahren nach einem der Ansprüche 1 bis 10, **dadurch gekennzeichnet, dass** die Passivierungsschicht (10) und/oder die Oxidschicht (2) nach dem Opferschichtätzschritt, insbesondere durch eine chemische Trockenätzung mit dem Gas HF/H₂O, wieder entfernt wird.

## Claims

1. Method for producing a micromechanical device, in particular a micromechanical oscillating mirror device, by exposing a vertically deflectable, in particular tiltable, island region (6) composed of silicon by means of an etching process in a silicon substrate layer (1) situated below the island region,
comprising the following steps:
- providing an SOI or epi-poly on insulator substrate having an Si functional layer (3), which is provided with the interposition of an oxide layer (2) on a silicon substrate layer (1), the upper region of which is provided as a sacrificial layer;
- forming at least one trench (5) extending through the functional layer (3) as far as the oxide layer (2) by means of a first anisotropic plasma etching step, which exposes the later island region (6) laterally relative to the functional layer (3);
- producing a passivation layer (10) covering at least the sidewalls of the trench (5), and subsequently opening the bottom of the trench as far as the silicon substrate layer (1) by means of a physical directional etching method,
- subjecting the trench (5) to depth etching by means of a second anisotropic plasma etching step from the opened bottom (11) of the trench into a predetermined depth of the silicon substrate layer (1), wherein this plasma etching step defines the depth of the sacrificial layer; and
- carrying out an isotropic sacrificial layer etching step for removing a region (12) of the sacrificial layer below the island region (6) by means of lateral undercutting of the silicon substrate layer (1) proceeding from the trench (5), in such a way that the island region (6) is exposed and made vertically movable.

2. Method according to Claim 1, **characterized in that** it is a method for producing a micromechanical oscillating mirror device.

3. Method according to Claim 1 or 2, **characterized in that** the sacrificial layer etching step is carried out selectively with respect to the passivation layer (10) and with respect to the oxide layer (2) .

4. Method for producing a micromechanical oscillating mirror device according to Claim 3, **characterized**
- **in that** the island region (6) is connected via one or a plurality of connecting webs (8) to the region (7) of the functional layer (3) which surrounds the island region (6),
- such that the exposed island region (6) can perform, around said one or said plurality of connecting webs (8), movements, preferably torsional oscillations, which have an amplitude such that a part of the island region (6) projects into the etched-free region (12) of the silicon substrate layer (1).

5. Method according to Claim 4, **characterized in that** narrow regions of the functional layer (3) that have been left are used as connecting webs (8).

6. Method according to any of Claims 1 to 5, **characterized in that** further trench structures (9) are provided within the island region (6) and are etched right into the sacrificial layer depth, such that the sacrificial layer etching step can be carried out simultaneously proceeding from all the trenches (5, 9).

7. Method according to Claim 6, **characterized in that** above the trench (5) and the further trench structures (9), embodied as perforation holes, at least one further layer (13), in particular improving the reflectivity of the mirror surface, is deposited in such a way that the perforation holes (9) are closed, but not the trench (5) separating the island region (6) from the surrounding region (7).

8. Method according to Claim 6 or 7, **characterized in that** the trench (5) laterally exposing the island region (6) is embodied such that it is wider than the further trench structures (9).

9. Method according to any of Claims 1 to 8, **characterized in that** the sacrificial layer etching step is carried out by chemical dry etching using one of the gases XeF₂, CIF₃, NF₃ or BrF₃.

10. Method according to any of Claims 1 to 9, **characterized in that** the passivation layer (10) is applied by CVD deposition or by thermal oxidation.

11. Method according to any of Claims 1 to 10, **characterized in that** the passivation layer (10) and/or the oxide layer (2) are/is removed again after the sacrificial layer etching step, in particular by a chemical dry etch using a gas HF/H₂O.

## Revendications

1. Procédé pour la fabrication d'un dispositif micromécanique, en particulier d'un dispositif de miroir oscillant micromécanique, par dégagement à partir de silicium d'une zone d'îlots (6) pouvant pivoter, en particulier basculer verticalement, au moyen d'un processus d'attaque dans une couche de substrat en silicium (1) se trouvant au-dessous de la zone d'îlots,
comportant les étapes
- disposition d'un substrat silicium sur isolant SOI ou d'un substrat epipoly sur isolant comportant une couche fonctionnelle de Si (3),
qui est prévue avec intercalation d'une couche d'oxyde (2) sur une couche de substrat en silicium (1), dont la partie supérieure est prévue en tant que couche sacrificielle ;
- formation d'au moins une tranchée (5) pénétrant à travers la couche fonctionnelle (3) jusqu'à la couche d'oxyde (2) au moyen d'une première étape de gravure au plasma anisotrope qui dégage la zone d'îlots (6) ultérieure latéralement par rapport à la couche fonctionnelle (3) ;
- production d'une couche de passivation (10) recouvrant au moins les parois latérales de la tranchée (5) et ouverture subséquence du fond de la tranchée jusqu'à la couche de substrat en silicium (I) par un procédé physique d'attaque orientée ;
- attaque profonde de la tranchée (5) par une deuxième étape d'attaque au plasma anisotrope du fond (11) de la tranchée ouverte jusqu'à une profondeur préétablie de la couche de substrat en silicium (1), cette étape d'attaque au plasma définissant la profondeur de la couche sacrificielle ; et
- excéution d'une étape d'attaque isotrope de la couche sacrificielle pour l'élimination d'une zone (12) de la couche sacrificielle au-dessous de la zone d'îlots (6) par attaque latérale par le dessous, à partir de la tranchée (5), de la couche de substrat en silicium (1), de sorte que la zone d'îlots (6) est dégagée et rendue mobile verticalement.

2. Procédé selon la revendication 1, **caractérisé en ce qu'**il s'agit d'un procédé destiné à la fabrication d'un dispositif de miroir oscillant micromécanique.

3. Procédé selon la revendication 1 ou 2, **caractérisé en ce que** l'étape d'attaque de la couche sacrificielle s'effectue sélectivement par rapport à la couche de passivation (10) et par rapport à la couche d'oxyde.

4. Procédé pour la fabrication d'un dispositif de miroir oscillant micromécanique selon la revendication 3, **caractérisé en ce**
- **que** la zone d'îlots (6) est attachée par une ou plusieurs barrettes de fixation (8) à la zone (7), entourant la zone d'îlots (6), de la couche fonctionnelle (3),
- de sorte que la zone d'îlots (6) dégagée peut effectuer autour de ladite une ou desdites plusieurs barrettes de fixation (8) des mouvements, de préférence des oscillations de torsion, qui ont une amplitude telle qu'une partie de la zone d'îlots (6) se dresse dans la zone dégagée par attaque (12) de la couche de substrat en silicium (1).

5. Procédé selon la revendication 4, **caractérisé en ce qu'**on utilise comme barrettes de fixation (8) de petites parties subsistantes de la couche fonctionnelle (3) .

6. Procédé selon l'une quelconque des revendications 1 à 5, **caractérisé en ce qu'**à l'intérieur de la zone d'îlots (6) d'autres structures de tranchées (9) sont prévues et gravées jusqu'à la profondeur de la couche sacrificielle, de sorte que l'étape d'attaque de la couche sacrificielle peut être effectuée simultanément en partant de toutes les tranchées (5, 9).

7. Procédé selon la revendication 6, **caractérisé en ce qu'**on dépose au-dessus de la tranchée (5) et des autres structures de tranchées (9), conçues en tant que trous engendrés par perforation, au moins une autre couche (13), en particulier améliorant la réflectivité de la surface du miroir, de sorte que les trous engendrés par perforation (9) sont obturés, mais non la tranchée (5) séparant la zone d'îlots (6) d'avec la zone (7) qui l'entoure.

8. Procédé selon la revendication 6 ou 7, **caractérisé en ce que** la tranchée (5) dégageant latéralement la zone d'îlots (6) est conçue plus large que les autres structures de tranchées (9).

9. Procédé selon l'une quelconque des revendications 1 à 8, **caractérisé en ce que** l'étape d'attaque de la couche sacrificielle s'effectue par attaque chimique à sec à l'aide de l'un des gaz XeF₂, ClF₃, NF₃ ou BrF₃.

10. Procédé selon l'une quelconque des revendications 1 à 9, **caractérisé en ce que** la couche de passivation (10) est appliquée par dépôt CVD ou par oxydation thermique.

11. Procédé selon l'une quelconque des revendications 1 à 10, **caractérisé en ce qu'**après l'étape d'attaque de la couche sacrificielle on élimine de nouveau la couche de passivation (10) et/ou la couche d'oxyde (2), en particulier par une attaque chimique à sec à l'aide du gaz HF/H₂O.
